# EUROPÄISCHE PATENTANMELDUNG

(11) **EP 4 707 968 A1**
(43) Veröffentlichungstag der Anmeldung: **11.03.2026**
(21) Anmeldenummer: 24199262.7
(22) Anmeldetag: 09.09.2024
(51) Int. Cl.: G05B 19/05, H05K 7/00

(54) **VERFAHREN ZUM BETREIBEN EINER PROZESSANLAGE ODER FERTIGUNGSANLAGE UND AUTOMATISIERUNGSGERÄT**

(71) Anmelder: Siemens Aktiengesellschaft, 80333 München (DE)
(72) Erfinder: Ates, Orhan, 76227 Karlsruhe (DE)
(74) Vertreter: Siemens Patent Attorneys

(57) **Zusammenfassung**

Die Erfindung betrifft ein Automatisierungsgerät (1) zur automatisierten Steuerung einer Prozessanlage oder Fertigungsanlage, umfassend eine speicherprogrammierbare Steuerung (11a, 11b), einen Rückwandbus (7), Schnittstellen (10), Anschlüsse (3) und ein Energiemodul (13a, 13b), wobei die speicherprogrammierbare Steuerung (11a, 11b), das Energiemodul (13a, 13b), die Schnittstellen (10) und die Anschlüsse (3) über den Rückwandbus (7) miteinander verbunden sind, und wobei das Energiemodul (13a, 13b) dazu ausgebildet und vorgesehen ist, die speicherprogrammierbare Steuerung (11a, 11b) mit elektrischer Energie für einen Steuerungsbetrieb zu versorgen, und wobei das Automatisierungsgerät (1) über wenigstens einen Teil der Anschlüsse (3) mit Sensoren (4, 5, 6) und Aktoren der Prozessanlage oder Fertigungsanlage verbindbar ist. Das Automatisierungsgerät (1) ist dadurch gekennzeichnet, dass es dazu ausgebildet ist, die über den wenigstens einen Teil der Anschlüsse (3) mit dem Automatisierungsgerät (1) verbundenen Sensoren (4, 5, 6) und Aktoren mit einer einstellbaren elektrischen Energie zu versorgen.

## Beschreibung

Die Erfindung betrifft ein Automatisierungsgerät zur automatisierten Steuerung einer Prozessanlage oder Fertigungsanlage. Zudem betrifft die Erfindung ein Leitsystem für eine Prozessanlage oder Fertigungsanlage und ein Verfahren zum automatisierten Betreiben einer Prozessanlage oder Fertigungsanlage.

Eine Stromversorgung einer speicherprogrammierbaren Steuerung eines Automatisierungs-gerätes versorgt das Automatisierungsgerät mit der notwendigen elektrischen Energie. An das Automatisierungsgerät angeschlossene Sensoren und Aktoren benötigen oftmals verschiedene Strom- bzw. Spannungsstärken und werden bei bekannten Automatisierungsgeräten mittels externer, zusätzlicher Energieversorgungsquellen mit der notwendigen elektrischen Energie versorgt.

Eine zusätzliche Erschwernis bei der Verwendung solcher externer, zusätzlicher Energieversorgungsquellen liegt darin, dass Automatisierungsgeräte bei gängigen Installationen in beengten Platzverhältnissen in einer Prozessanlage oder Fertigungsanlage untergebracht sind und der Platz für zusätzliche Energieversorgungsquellen mitsamt der nötigen Verkabelung begrenzt ist. Zudem wird die elektrische Installation unübersichtlich und damit auch fehleranfällig.

Die EP 1 119 802 A1 offenbart eine Vorrichtung zur Steuerung und/oder Überwachung externer technischer Prozesse.

Der Erfindung liegt die Aufgabe zugrunde, ein Automatisierungsgerät anzugeben, welches eine einfache, effiziente und fehlerunanfällige Steuerung von Sensoren und Aktoren zum automatisierten Betrieb einer Prozessanlage oder Fertigungsanlage ermöglicht.

Diese Aufgabe wird gelöst durch ein Automatisierungsgerät zur automatisierten Steuerung einer Prozessanlage oder Fertigungsanlage mit den Merkmalen des Anspruchs 1. Außerdem wird die Aufgabe gelöst durch ein Leitsystem für eine Prozessanlage oder Fertigungsanlage nach Anspruch 8. Zudem wird die Aufgabe gelöst durch ein Verfahren zum automatisierten Betreiben einer Prozessanlage oder Fertigungsanlage nach Anspruch 11. Vorteilhafte Weiterbildungen ergeben sich aus den abhängigen Ansprüchen.

Es wird von einem Automatisierungsgerät zur automatisierten Steuerung einer Prozessanlage oder Fertigungsanlage ausgegangen, welches eine speicherprogrammierbare Steuerung, einen Rückwandbus, Schnittstellen, Anschlüsse und ein Energiemodul umfasst. Dabei sind die speicherprogrammierbare Steuerung, die Schnittstellen, die Anschlüsse und das Energiemodul über den Rückwandbus miteinander verbunden.

Das Energiemodul ist dazu ausgebildet und vorgesehen, die speicherprogrammierbare Steuerung mit elektrischer Energie für einen Steuerungsbetrieb zu versorgen. Dabei ist das Automatisierungsgerät über wenigstens einen Teil der Anschlüsse mit Sensoren und Aktoren der Prozessanlage oder Fertigungsanlage verbindbar.

Das Automatisierungsgerät ist erfindungsgemäß dadurch gekennzeichnet, dass es dazu ausgebildet ist, die über den wenigstens einen Teil der Anschlüsse mit dem Automatisierungsgerät verbundenen Sensoren und Aktoren mit einer einstellbaren elektrischen Energie zu versorgen.

Bei der Anlage kann es sich um eine Anlage aus der Prozessindustrie (Prozessanlage) wie beispielsweise eine chemische, pharmazeutische, petrochemische oder eine Anlage aus der Nahrungs- und Genussmittelindustrie handeln. Eine Anlage kann auch eine Fertigungsanlage der Produktionsindustrie sein, womit Werke gemeint sind, in denen z.B. Autos oder Güter aller Art produziert werden.

Unter einer Automatisierung wird die selbständige (automatisierte) Erfassung und Beeinflussung physikalischer Größen mithilfe technischer Mittel verstanden. Dabei werden in der Regel Maschinen, Anlagen oder sonstige Einrichtungen in die Lage versetzt, selbsttätig zu arbeiten. Die Automatisierung umfasst wenigstens eine Parametrierung der Komponenten der Anlage und eine Interaktion der Komponenten mit weiteren Komponenten. Automatisierungsgeräte werden zur Realisierung einer Automatisierung benutzt und können Teil eines Leitsystems sein, das eine übergeordnete Steuerungsfunktion für die untergeordnete speicherprogrammierbare Steuerung wahrnimmt. Die Erfindung geht von einem Automatisierungsgerät aus, welches wenigstens eine speicherprogrammierbare Steuerung aufweist, auf welcher ein Programm zum automatisierten Betrieb der Prozessanlage oder Fertigungsanlage abläuft bzw. ablaufen kann.

Unter einem Leitsystem wird im vorliegenden Kontext ein computergestütztes, technisches System verstanden, das Funktionalitäten zum Darstellen, Bedienen und Leiten der technischen Anlage umfasst. Das Leitsystem kann auch Sensoren zur Ermittlung von Messwerten sowie verschiedene Aktoren umfassen. Zudem kann das Leitsystem sogenannte prozess- oder fertigungsnahe Komponenten umfassen, die zur Ansteuerung der Aktoren bzw. Sensoren dienen.

Darüber hinaus kann das Leitsystem u.a. Mittel zur Visualisierung der verfahrenstechnischen Anlage und zu einem Engineering aufweisen. Das Leitsystem kann optional auch weitere Recheneinheiten für komplexere Regelungen und Systeme zur Datenspeicherung und -verarbeitung umfassen.

Das Automatisierungsgerät weist ein Energiemodul auf, welches die speicherprogrammierbare Steuerung und ggf. weitere Komponenten des Automatisierungsgerätes mit der notwendigen elektrischen Energie versorgt. Dieses Energiemodul kann eine eigene Energiequelle wie eine Batterie oder eine Photovoltaikzelle aufweisen. Das Energiemodul kann aber auch einen Netzanschluss zu einem (externen) elektrischen Energienetz aufweisen.

Der Rückwandbus stellt ein Kommunikationssystem dar, welcher in Automatisierungsgeräten mit speicherprogrammierbaren Steuerungen (SPS) verwendet wird. Der Rückwandbus verbindet die verschiedenen Baugruppen (z.B. digitale Eingänge, digitale Ausgänge, analoge Eingänge) mit der zentralen Verarbeitungseinheit (der CPU) der speicherprogrammierbaren Steuerung.

Ein Teil der Anschlüsse des Automatisierungsgerätes ist dafür ausgelegt und vorgesehen, mit Sensoren und Aktoren und ggf. weiteren Feldkomponenten der Prozessanlage oder der Fertigungsanlage verbunden zu werden. Hierfür kann beispielsweise eine auf Industrial Ethernet oder HART basierende Kommunikation verwendet werden. Ein Teil der Schnittstellen des Automatisierungsgerätes kann dazu ausgebildet und vorgesehen sein, mit übergeordneten Komponenten des Leitsystems wie einem Operator Station Server oder einem Engineering Station Server verbunden zu werden. Diese Kommunikation kann beispielsweise auf Industrial Ethernet basieren. Die Verbindungen können kabelgebunden oder kabellos sein, wobei im Falle einer kabellosen Verbindung beispielsweise Bluetooth oder 5G für die Kommunikation verwendet werden können.

Das erfindungsgemäße Automatisierungsgerät ist dazu ausgebildet, die mit dem Automatisierungsgerät verbundenen Sensoren und Aktoren, und ggf. weitere Feldkomponenten der Prozessanlage oder Fertigungsanlage mit einer einstellbaren elektrischen Energie zu versorgen. Dies bedeutet zum einen, dass keine externe, zusätzliche Energieversorgung für die Sensoren und Aktoren benötigt wird, da das Automatisierungsgerät diese Energie zusätzlich zur Verfügung stellt. Zum anderen bedeutet "einstellbar", dass diese zusätzliche Energieversorgung an die individuellen Bedürfnisse der Sensoren und Aktoren, insbesondere hinsichtlich einer elektrischen Spannung oder eines elektrischen Stromes, angepasst werden kann. Diese Anpassung kann von einem Operator der Prozessanlage oder Fertigungsanlage vorgenommen werden. Es ist aber auch möglich, dass das Automatisierungsgerät diese Anpassung eigenständig, d.h. automatisiert vornimmt.

Im Rahmen einer vorteilhaften Weiterbildung der Erfindung umfasst das Automatisierungsgerät ein Energieversorgungsmodul, welches über den Rückwandbus mit dem (zentralen) Energiemodul verbunden ist. Dabei ist das Energiemodul dazu ausgebildet und vorgesehen, das Energieversorgungsmodul mit elektrischer Energie zu versorgen. Das Energieversorgungsmodul weist wiederum Anschlüsse zur Versorgung der mit dem Automatisierungsgerät verbindbaren Sensoren und Aktoren mit elektrischer Energie auf. Das Energieversorgungsmodul übernimmt demnach die Energieversorgung der an das Automatisierungsgerät angeschlossenen Sensoren und Aktoren.

Dabei weist das Energieversorgungsmodul vorteilhafterweise eine Recheneinheit auf, die dazu ausgebildet ist, die an die mit dem Automatisierungsgerät verbindbaren Sensoren und Aktoren übertragene elektrische Energie zu steuern. Das Energieversorgungsmodul ist dadurch in der Lage, die Menge an elektrischer Energie zu steuern, indem es insbesondere bestimmte Spannungs- und Stromwerte den jeweiligen Sensoren und Aktoren zur Verfügung stellt.

Bevorzugt ist die Recheneinheit dazu ausgebildet, über den Rückwandbus von der speicherprogrammierbaren Steuerung Steueranweisungen bezüglich der Steuerung der an die mit dem Automatisierungsgerät verbindbaren Sensoren und Aktoren übertragenen elektrischen Energie zu empfangen. Mit anderen Worten überträgt die speicherprogrammierbare Steuerung über den Rückwandbus Anweisungen an das Energieversorgungsmodul, genauer: an die Recheneinheit des Energieversorgungsmoduls.

Um die Steueranweisungen zu erhalten, kann das Automatisierungsgerät eine grafische Nutzerschnittstelle bereitstellen. Hierüber Operator der Prozessanlage oder Fertigungsanlage vorgeben kann, an welchen Sensor oder Aktor welche Menge an elektrischer Energie, insbesondere durch das Energieversorgungsmodul, bereitgestellt werden soll.

Besonders bevorzugt ist das Automatisierungsgerät dazu ausgebildet, grafisch anzuzeigen, für welchen Sensor oder Aktor zu einem aktuellen Zeitpunkt welche Menge an elektrischer Energie bereitgestellt wird. Hierfür kann das Automatisierungsgerät eine grafische Anzeige wie einen LED-Bildschirm aufweisen, welcher beispielsweise den an einen Sensor aktuell ausgegebenen Spannungswert anzeigt.

Die zuvor formulierte Aufgabe wird zudem gelöst durch ein Automatisierungsgerät, das wie zuvor erläutert ausgebildet ist, mit Sensoren und Aktoren, wobei die Sensoren und Aktoren mit wenigstens einem Teil der Schnittstellen des Automatisierungsgerätes verbunden sind.

Die zuvor formulierte Aufgabe wird zudem gelöst durch ein Leitsystem für eine Prozessanlage oder Fertigungsanlage, umfassend ein Automatisierungsgerät wie zuvor erläutert und einen mit dem Automatisierungsgerät verbundenen Operator Station Server, welcher zur Bedienung und Beobachtung durch einen Operator der Prozessanlage oder Fertigungsanlage ausgebildet ist. Unter einem "Operator Station Server" wird vorliegend ein Server verstanden, der zentral Daten eines Bedien- und Beobachtungssystems sowie in der Regel Alarm- und Messwertarchive eines Leitsystems einer Prozessanlage oder Fertigungsanlage erfasst und Benutzern zur Verfügung stellt. Der Operator Station Server stellt in der Regel eine Kommunikationsverbindung zu dem Automatisierungsgerät der Anlage her und gibt Daten der Anlage an sogenannte Clients weiter, die zur Bedienung und Beobachtung eines Betriebs der einzelnen Funktionselemente der technischen Anlage dienen. Der Operator Station Server kann über Client-Funktionen verfügen, um auf die Daten (Archive, Meldungen, Tags, Variablen) anderer Operator Station Server zuzugreifen. Dadurch sind Bilder eines Betriebs der Anlage auf dem Operator Station Server mit Variablen anderer Operator Station Server (Server-Server-Kommunikation) kombinierbar. Bei dem Operator Station Server kann es sich, ohne sich darauf zu beschränken, um einen SIMATIC PCS 7 Industrial Workstation Server der Firma SIEMENS handeln.

Es kann durch einen Operator der Prozessanlage oder Fertigungsanlage vorgebbar sein, an welchen Sensor oder Aktor welche Menge an elektrischer Energie durch das Automatisierungsgerät, insbesondere durch das Energieversorgungsmodul des Automatisierungsgerätes, bereitgestellt werden soll. Die Vorgabe durch den Operator mittels des Operator Station Servers kann alternativ oder zusätzlich zu der Möglichkeit vorgesehen sein, die Vorgabe direkt in dem Automatisierungsgerät vorzunehmen, was zuvor erläutert wurde.

Die zuvor erläuterte Aufgabe wird zudem gelöst durch ein Leitsystem, das wie zuvor erläutert ausgebildet ist, mit Sensoren und Aktoren, mit wenigstens einem Teil der Anschlüsse des Automatisierungsgerätes verbunden sind.

Die zuvor erläuterte Aufgabe wird zudem gelöst durch ein Verfahren zum automatisierten Betreiben einer Prozessanlage oder Fertigungsanlage mit einem Automatisierungsgerät wie zuvor erläutert, das Verfahren umfassend:
a) Herstellen einer Verbindung zwischen Anschlüssen des Automatisierungsgerätes und Sensoren und Aktoren der Prozessanlage oder Fertigungsanlage,
b) Herstellen einer elektrischen Energieversorgung für das Energiemodul des Automatisierungsgerätes,
c) Versorgen der mit dem Automatisierungsgerät verbundenen Sensoren und Aktoren mit elektrischer Energie durch das Automatisierungsgerät,
d) Automatisiertes Betreiben der Prozessanlage oder Fertigungsanlage mithilfe der Sensoren und Aktoren.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Es zeigen:
FIG 1 ein erfindungsgemäßes Automatisierungsgerät in einer schematischen Darstellung; und
FIG 2 ein erfindungsgemäßes Leitsystem mit Sensoren und Aktoren in einer schematischen Darstellung.

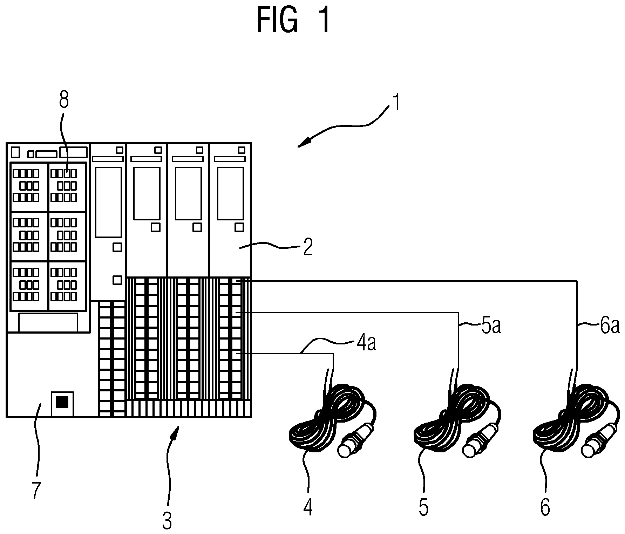

In FIG 1 ist ein Teil eines Automatisierungsgerätes 1 dargestellt. Das Automatisierungsgerät 1 weist ein Energieversorgungsmodul 2 auf, welches eine Vielzahl von Anschlüssen 3 aufweist. An diesen Anschlüssen 3 sind in FIG 1 drei Sensoren 4, 5, 6 mittels dreier Verbindungskabel 4a, 5a, 6a angeschlossen (in FIG 1 schematisch dargestellt). Die Verbindungen 4a, 5a, 6a können auch kabellos, insbesondere über Bluetooth, ausgebildet sein.

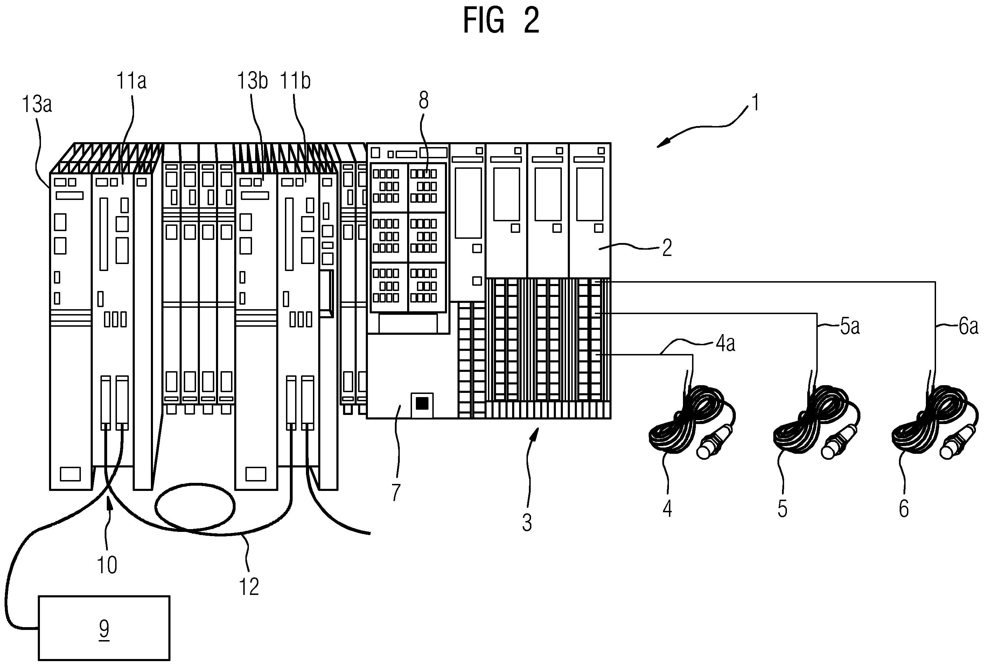

Das Automatisierungsgerät 1 weist zudem einen Rückwandbus 7 auf, mittels dessen das Energieversorgungsmodul 2 mit Schnittstellen, einer speicherprogrammierbaren Steuerung und einem Energiemodul des Automatisierungsgerätes 1 verbunden ist (vgl. FIG 2). Das Automatisierungsgerät 1 weist weiterhin eine grafisch Anzeige 8 auf, über die einem Operator einer mit dem Automatisierungsgerät 1 automatisiert betriebenen Prozessanlage oder Fertigungsanlage angezeigt wird, welche Spannung und welchen Strom das Energieversorgungsmodul 2 den Sensoren 4, 5, 6 bereitstellt.

In FIG 2 ist das Automatisierungsgerät 1 mit den Sensoren 4, 5, 6 und einem mit einer Schnittstelle 10 des Automatisierungsgeräts 1 verbundenen Operator Station Server 9 dargestellt. Das Automatisierungsgerät 1 weist eine erste speicherprogrammierbare Steuerung 11a und eine zweite speicherprogrammierbare Steuerung 11b auf, die für einen redundanten Betrieb der Automatisierung über eine Synchronisationsleitung 12 miteinander verbunden sind. Zudem weist das Automatisierungsgerät 1 ein erstes Energiemodul 13a und ein zweites Energiemodul 13b auf, die jeweils mit einer externen Energieversorgung (nicht dargestellt) verbunden sind.

Die Energiemodule 13a, 13b sind jeweils dazu ausgebildet und vorgesehen, die speicherprogrammierbare Steuerung 11a, 11b mit elektrischer Energie für einen Steuerungsbetrieb zu versorgen. Die Energiemodule 13a, 13b versorgen zudem das Energieversorgungsmodul 2 über den Rückwandbus 7 mit der für den Betrieb der Sensoren 4, 5, 6 notwendigen elektrischen Energie. Dabei kann die Energieversorgung über eines der beiden Energiemodule 13a, 13b oder über beiden Energiemodule 13a, 13b erfolgen.

In dem Operator Station Server 9 ist durch einen Operator der Prozessanlage oder Fertigungsanlage vorgebbar, an welchen Sensor oder Aktor welche Menge an elektrischer Energie durch die Anschlüsse des Energieversorgungsmoduls 2 bereitgestellt werden soll. Dabei kann der Operator insbesondere festlegen, welche Spannung und welcher Strom für welchen Sensor 4, 5, 6 bereitgestellt werden soll.

Das Automatisierungsgerät 1 macht den Einsatz von externen Energieversorgungen für die Sensoren 4, 5, 6 überflüssig.

### Bezugszeichenliste

- 1: Automatisierungsgerät
- 2: Energieversorgungsmodul
- 3: Anschlüsse
- 4: Sensor
- 5: Sensor
- 6: Sensor
- 4a: Verbindung
- 5a: Verbindung
- 6a: Verbindung
- 7: Rückwandbus
- 8: Grafische Anzeige
- 9: Operator Station Server
- 10: Schnittstelle
- 11a: Erster speicherprogrammierbare Steuerung
- 11b: Zweite speicherprogrammierbare Steuerung
- 12: Verbindungskabel
- 13a: Erstes Energiemodul
- 13b: Zweites Energiemodul

## Patentansprüche

1. Automatisierungsgerät (1) zur automatisierten Steuerung einer Prozessanlage oder Fertigungsanlage, umfassend eine speicherprogrammierbare Steuerung (11a, 11b), einen Rückwandbus (7), Schnittstellen (10), Anschlüsse (3) und ein Energiemodul (13a, 13b),
wobei die speicherprogrammierbare Steuerung (11a, 11b), das Energiemodul (13a, 13b), die Schnittstellen (10) und die Anschlüsse (3) über den Rückwandbus (7) miteinander verbunden sind,
und wobei das Energiemodul (13a, 13b) dazu ausgebildet und vorgesehen ist, die speicherprogrammierbare Steuerung (11a, 11b) mit elektrischer Energie für einen Steuerungsbetrieb zu versorgen,
und wobei das Automatisierungsgerät (1) über wenigstens einen Teil der Anschlüsse (3) mit Sensoren (4, 5, 6) und Aktoren der Prozessanlage oder Fertigungsanlage verbindbar ist, **dadurch gekennzeichnet, dass**
das Automatisierungsgerät (1) dazu ausgebildet ist, die über den wenigstens einen Teil der Anschlüsse (3) mit dem Automatisierungsgerät (1) verbundenen Sensoren (4, 5, 6) und Aktoren mit einer einstellbaren elektrischen Energie zu versorgen.

2. Automatisierungsgerät (1) nach Anspruch 1, welches ein Energieversorgungsmodul (2) umfasst, welches über den Rückwandbus (7) mit dem Energiemodul (13a, 13b) verbunden ist, wobei das Energiemodul (13a, 13b) dazu ausgebildet und vorgesehen ist, das Energieversorgungsmodul (2) mit elektrischer Energie zu versorgen, und wobei das Energieversorgungsmodul Anschlüsse (3) zur Versorgung der mit dem Automatisierungsgerät (1) verbindbaren Sensoren (4, 5, 6) und Aktoren mit elektrischer Energie aufweist.

3. Automatisierungsgerät (1) nach Anspruch 2, bei dem das Energieversorgungsmodul (2) eine Recheneinheit aufweist, die dazu ausgebildet ist, die an die mit dem Automatisierungsgerät (1) verbindbaren Sensoren (4, 5, 6) und Aktoren übertragene elektrische Energie zu steuern.

4. Automatisierungsgerät (1) nach Anspruch 3, bei dem die Recheneinheit dazu ausgebildet ist, über den Rückwandbus (7) von der speicherprogrammierbaren Steuerung (11a, 11b) Steueranweisungen bezüglich der Steuerung der an die mit dem Automatisierungsgerät (1) verbindbaren Sensoren (4, 5, 6) und Aktoren übertragene elektrische Energie zu empfangen.

5. Automatisierungsgerät (1) nach einem der vorangegangenen Ansprüche, bei dem die speicherprogrammierbare Steuerung (11a, 11b) eine grafische Nutzerschnittstelle bereitstellt, über die ein Operator der Prozessanlage oder Fertigungsanlage vorgeben kann, an welchen Sensor (4, 5, 6) oder Aktor welche Menge an elektrischer Energie, insbesondere durch das Energieversorgungsmodul (2), bereitgestellt werden soll.

6. Automatisierungsgerät (1) nach einem der vorangegangenen Ansprüche, welches dazu ausgebildet ist, grafisch anzuzeigen, für welchen Sensor (4, 5, 6) oder Aktor zu einem aktuellen Zeitpunkt welche Menge an elektrischer Energie bereitgestellt wird, insbesondere über eine grafische Anzeige (8).

7. Automatisierungsgerät (1) mit Sensoren und Aktoren, die mit wenigstens einem Teil der Anschlüsse (3) des Automatisierungsgerätes (1) verbunden sind.

8. Leitsystem für eine Prozessanlage oder Fertigungsanlage, umfassend ein Automatisierungsgerät (1) gemäß einem der Ansprüche 1 bis 7 und einen mit dem Automatisierungsgerät (1) verbundenen Operator Station Server (9), welcher zur Bedienung und Beobachtung durch einen Operator der Prozessanlage oder Fertigungsanlage ausgebildet ist.

9. Leitsystem nach Anspruch 8, bei dem in dem Operator Station Server (9) durch einen Operator der Prozessanlage oder Fertigungsanlage vorgebbar ist, an welchen Sensor (4, 5, 6) oder Aktor welche Menge an elektrischer Energie durch das Automatisierungsgerät (1), insbesondere durch das Energieversorgungsmodul (2) des Automatisierungsgerätes (1), bereitgestellt werden soll.

10. Leitsystem nach Anspruch 8 oder 9 mit Sensoren (4, 5, 6) und Aktoren, die mit wenigsten einem Teil der Anschlüsse (3) des Automatisierungsgerätes (1) verbunden sind.

11. Verfahren zum automatisierten Betreiben einer Prozessanlage oder Fertigungsanlage mit einem Automatisierungsgerät (1) gemäß einem der Ansprüche 1 bis 7, umfassend:
a) Herstellen einer Verbindung zwischen Anschlüssen (3) des Automatisierungsgerätes (1) und Sensoren (4, 5, 6) und Aktoren der Prozessanlage oder Fertigungsanlage,
b) Herstellen einer elektrischen Energieversorgung für das Energiemodul (13a, 13b) des Automatisierungsgerätes (1),
c) Versorgen der mit dem Automatisierungsgerät (1) verbundenen Sensoren (4, 5, 6) und Aktoren mit elektrischer Energie durch das Automatisierungsgerät (1),
d) Automatisiertes Betreiben der Prozessanlage oder Fertigungsanlage mithilfe der Sensoren (4, 5, 6) und Aktoren.
